# EUROPÄISCHE PATENTANMELDUNG

(11) **EP 4 550 615 A1**
(43) Veröffentlichungstag der Anmeldung: **07.05.2025**
(21) Anmeldenummer: 24209742.6
(22) Anmeldetag: 30.10.2024
(51) Int. Cl.: H02J 7/00, G01R 31/367, G01R 31/392, H01M 10/44, H01M 10/48, B60L 58/16

(54) **SYSTEM UND VERFAHREN ZUM OPTIMIERTEN STEUERN EINER BATTERIE**

(30) Priorität: 31.10.2023 DE 102023130120
(71) Anmelder: reLi Energy GmbH, 64293 Darmstadt (DE)
(72) Erfinder: Rathinam, Krishna Kumar, 64283 Darmstadt (DE); Laringe, Laura, 64293 Darmstadt (DE); Baskar, Ashish, 64289 Darmstadt (DE)
(74) Vertreter: WSL Patentanwälte Partnerschaft mbB

(57) **Zusammenfassung**

Die vorliegende Erfindung betrifft ein System zum optimierten Steuern einer Batterie sowie ein computer-implementiertes Verfahren zum Steuern des Lade- oder Entladevorgangs einer Batterie.

## Beschreibung

Die vorliegende Erfindung betrifft ein System zum optimierten Steuern einer Batterie sowie ein computer-implementiertes Verfahren zum Steuern des Lade- oder Entladevorgangs einer Batterie.

Die Kapazität und das Leistungsvermögen von Batterien, insbesondere Lithium-lonen Batterien, sind Alterungsprozessen ausgesetzt. So nimmt die Kapazität grundsätzlich mit dem Lebensalter der Batterie ab (calender aging). Aber auch das Lade- und Entladeverhalten beeinflusst die zeitliche Entwicklung der Kapazität und des Leistungsvermögen (cycle aging).

Die Alterungsprozesse können mit nicht-lineare mathematische Modellen beschrieben werden, z.B. durch eine Arrhenius Gleichung. Gleichzeitig ist es zum Beispiel wünschenswert, die Lade- und Entladevorgänge von Batterien derart zu steuern, dass die Batterie innerhalb eines entsprechenden Verbrauchersystem eine besonders lange Lebensdauer und/oder einen möglichst geringen ökologischen Fußabdruck aufweist.

Vor diesem Hintergrund ist eine Aufgabe der vorliegenden Erfindung, eine System und ein Verfahren bereitzustellen, mit dem auf besonders energieeffiziente Art und Weise die Lade- oder Entladevorgänge einer Batterie gesteuert werden können, um eine Optimierung eines wirtschaftlichen, ökologischen und/oder technologischen Kennwerts zu bewirken.

Diese Aufgabe wird gelöst durch ein System zum optimierten Steuern einer Batterie, wobei das System eine Datenerfassungseinrichtung, insbesondere einen Prozessor umfassende Datenerfassungseinrichtung, umfasst, wobei das System eine Berechnungseinrichtung, insbesondere eine als Prozessor ausgebildete Berechnungseinrichtung, umfasst, wobei das System eine Steuereinrichtung, insbesondere eine einen Prozessor umfassende Steuereinrichtung, umfasst, wobei die Datenerfassungseinrichtung derart ausgebildet und eingerichtet ist, dass sie einen Parameterwert eines physikalischen und zeitlich variablen Zustandsparameters einer Batterie erfasst und der Berechnungseinrichtung zu Verfügung stellt, wobei die Berechnungseinrichtung derart ausgebildet und eingerichtet ist, dass die Berechnungseinrichtung mittels einer Optimierungsrechnung einen Parameterwert eines Steuerparameters ermittelt, wobei die Berechnungseinrichtung derart eingerichtet ist, dass mit der Optimierungsrechnung ein Optimierungsparameter minimiert oder maximiert wird, wobei die Berechnungseinrichtung derart eingerichtet ist, dass die Berechnungseinrichtung die Optimierungsrechnung in Abhängigkeit von einem mathematischen Modell des zeitlichen Verhaltens der Batterie durchführt, wobei mit dem mathematischen Modell der Optimierungsparameter in Abhängigkeit von dem Zustandsparameter berechenbar ist, wobei die Berechnungseinrichtung derart eingerichtet ist, dass die Berechnungseinrichtung den von der Datenerfassungseinrichtung erfassten und der Berechnungseinrichtung zu Verfügung gestellten Parameterwert des physikalischen und zeitlich variablen Zustandsparameters als Eingangsparameterwert für die Optimierungsrechnung verwendet, wobei die Steuereinrichtung derart ausgebildet und eingerichtet ist, dass die Steuereinrichtung ein Aufladen und/oder Entladen der Batterie in Abhängigkeit von dem ermittelten Parameterwert des Steuerparameters steuert. Insbesondere kann die Steuereinrichtung derart ausgebildet und eingerichtet sein, dass die Steuereinrichtung das Entladen der Batterie in Abhängigkeit von dem ermittelten Parameterwert des Steuerparameters steuert

Dieses System ermöglicht es, den Auf- und Entladevorgang der Batterie (insbesondere den Entladevorgang) derart optimiert zu steuern, dass bestimmte ökonomische und/oder ökologische Ziele erreicht werden. Insbesondere kann die Batterie derart gesteuert werden, dass eine maximal erwartbare Lebensdauer der Batterie oder ein Minimum an Energiekosten erreicht wird. Um beispielsweise eine maximal erwartbare Lebensdauer zu erreichen, kann die Berechnungseinrichtung derart eingerichtet werden, dass die Optimierungsrechnung die mit dem mathematischen Modell berechenbare erwartbare Lebensdauer maximiert und mittels dieser Optimierungsrechnung Parameterwerte des Steuerparameters oder mehrere Steuerparameter bestimmt, mit denen dieses Ziel - das Maximieren der Lebensdauer der Batterie - gemäß dem mathematischen Modell erreicht wird. Um beispielsweise ein Minimum an Energiekosten zu erreichen, kann die Berechnungseinrichtung derart eingerichtet sein, dass das mathematische Modell Realzeit-Informationen über die am Standort der Batterie erhältlichen Strompreise enthält, sodass beispielsweise der Startpunkt eines Aufladevorgangs einen Steuerparameter darstellt, für den sich ein Parameterwert im Sinne einer Uhrzeit aus der Optimierungsrechnung ergibt.

Unter einem mathematischen Modell ist im Sinne der vorliegenden Erfindung eine mathematische Gleichung oder ein mathematisches Gleichungssystem zu verstehen, mit dem das zeitliche Verhalten, insbesondere der Alterungsprozess, einer Batterie beschreibbar ist.

Unter einer Optimierungsrechnung ist im Sinne der vorliegenden Erfindung ein computer-implementierter Algorithmus und dessen Ausführung zu verstehen, wobei der Algorithmus eine sich aus dem mathematischen Modell und der Minimierung oder Maximierung eines Optimierungsparameters ergebene mathematisch Gleichung oder ein sich hieraus ergebenes Gleichungssystem löst, insbesondere numerisch löst, sodass ein Parameterwert eines Steuerparameters oder Parameterwerte für mehrere Steuerparameter erhalten werden. Ein solcher computer-implementierter Algorithmus wird auch als Solver bezeichnet.

Gemäß einer Ausführungsform des erfindungsgemäßen Systems ist die Batterie als stationäre Batterie ausgebildet. Unter einer stationären Batterie ist insbesondere eine Batterie zu verstehen, die nicht als Batterie zum Betreiben eines Fahrzeugs verwendet wird bzw. dazu geeignet ist.

Insbesondere kann die Batterie eine maximale Ladekapazität aufweisen, die größer ist als 1 kWh, vorzugsweise größer ist als 8 kWh. Insbesondere kann die maximale Ladekapazität ausgewählt sein aus einem Intervall von 8 kWh bis zu einer Vielzahl von GWh, weiterhin insbesondere aus einem Intervall von 8 kWh bis 10 GWh. Die Batterie kann insbesondere als Industrie- oder Netzbatterie konzipiert werden, die nicht für kleinere elektronische Geräte oder im Automobilbereich genutzt wird. Insbesondere kann die Batterie auch derart ausgebildet sein, dass sie nicht für den Einsatz bei kleineren elektronischen Geräten und im Automobilbereich geeignet ist.

Gemäß einer Ausführungsform des erfindungsgemäßen Systems ist die Steuereinrichtung derart ausgebildet, dass die Steuereinrichtung den zeitlichen Verlauf des Auflade-Stroms und/oder den zeitlichen Verlauf des Entlade-Stroms in Abhängigkeit von dem ermittelten Parameterwert des Steuerparameters steuert. Hierzu kann die Steuereinrichtung insbesondere die Start- und Stoppzeit für das Aufladen oder Entladen sowie den beim Auf- oder Entladen verwendeten Energiefluss steuern. Hierdurch können neben der zu erwartenden Lebensdauer der Batterie insbesondere auch die Energiekosten und die CO2-Emission des Batteriebetriebs optimiert werden

Gemäß einer Ausführungsform des erfindungsgemäßen Systems ist der Steuerparameter ausgewählt aus der folgenden Gruppe von möglichen Steuerparametern: Status des Aufladens mit den beiden einzig möglichen Parameterwerten on und off, Status des Entladens mit den beiden einzig möglichen Parameterwerten on und off, Startzeit des Aufladens, Stoppzeit des Aufladens, Startzeit des Entladens, Stoppzeit des Entladens, Maximaler Auflade-Strom, Maximaler Entlade-Strom. Hierdurch kann das zeitliche Auf- bzw. Entladeverhalten der Batterie besonders einfach und energieeffizient gesteuert werden. Zur Steuerung der Steuerparameter kann die Steuereinrichtung als direkte, indirekte oder Status-Steuerung ausgebildet sein.

Gemäß einer Ausführungsform des erfindungsgemäßen Systems ist der Zustandsparameter ausgewählt aus der folgenden Gruppe von möglichen Zustandsparametern: Aufladungsgrad der Batterie, Entladungsgrad der Batterie, Energiefluss in die Batterie beim Aufladen, Energiefluss aus der Batterie beim Entladen, Temperatur der Batterie, Alter der Batterie, gemittelter Aufladungsgrad über einen Zeitraum T, gemittelter Entladungsgrad über einen Zeitraum T, Maximaler Entladungsgrad in einem Zeitraum T. Der Zeitraum T ist gemäß einer bevorzugten Ausführungsform ein Tag, also 24 Stunden, insbesondere der zum Zeitpunkt des Erfassens zurückliegende Zeitraum von 24 Stunden. Der Zeitraum T kann aber auch kleinere oder größere Zeiträume abdecken, zum Beispiel eine Stunde oder 15 Minuten. Durch die Mittelung kann die von der Berechnungseinrichtung durchzuführende Optimierungsrechnung vereinfacht werden, was die Berechnung energieeffizienter und schneller macht. Der gewählte Zeitraum T stellt das zeitliche Optimierungsfenster dar.

Gemäß einer Ausführungsform des erfindungsgemäßen Systems ist die Datenerfassungseinrichtung derart ausgebildet und eingerichtet, dass die Datenerfassungseinrichtung eine an der Batterie anliegende elektrische Spannung, einen in die oder aus der Batterie fließenden elektrischen Strom und eine in der Batterie herrschenden Temperatur misst, wobei die Datenerfassungseinrichtung vorzugsweise derart ausgebildet und eingerichtet ist, dass die Datenerfassungseinrichtung den Aufladungsgrad der Batterie oder den Entladungsgrad der Batterie auf Basis der gemessenen Spannung und/oder des gemessenen Stroms und/oder der gemessenen Temperatur bestimmt. Dies ist eine besonders einfache, schnelle und ressourcenschonende Implementierung, mit welcher Parameterwerte des Zustandsparameters Aufladungsgrad, Entladungsgrad bzw. entsprechende über den Zeitraum T gemittelte Werte ermittelt werden können. Insbesondere sind zur Bereitstellung einer entsprechenden Datenerfassungseinrichtung keine oder nur wenige zusätzliche Hardwarekomponenten notwendig als diejenigen, die bei einer gewöhnlichen Batterie-Steuereinheit verfügbar sind.

Gemäß einer Ausführungsform des erfindungsgemäßen Systems ist die Berechnungseinrichtung derart ausgebildet und eingerichtet, dass mit der auf dem mathematischen Modell beruhenden Optimierungsrechnung der Optimierungsparameter in multivariabler Abhängigkeit von mehreren der folgenden Zustandsparametern berechenbar ist: Aufladungsgrad der Batterie, Entladungsgrad der Batterie, Energiefluss in die Batterie beim Aufladen, Energiefluss aus der Batterie beim Entladen, Temperatur der Batterie, Alter der Batterie, gemittelter Aufladungsgrad über einen Zeitraum T, gemittelter Entladungsgrad über einen Zeitraum T, Maximaler Entladungsgrad in einem Zeitraum T; wobei die Datenerfassungseinrichtung zumindest Parameterwerte derjenigen Zustandsparameter erfasst, von denen das mathematische Modell abhängig ist, und der Berechnungseinrichtung zu Verfügung stellt. Zwar wird die Komplexität der Optimierungsrechnung durch die Beachtung multivariabler Zusammenhänge erhöht, die Genauigkeit des zugrundeliegenden Mathematischen Models und der mit der Optimierungsrechnung zusammenhängenden Voraussage für den verwendeten Optimierungsparameter - wie beispielsweise die Lebensdauer der Batterie - steigt aber mit Einbeziehung multivariabler Zusammenhänge an.

So kann beispielsweise die Datenerfassungseinrichtung derart eingerichtet sein, dass sowohl ein Parameterwert der Temperatur als auch ein Parameterwert des Aufladungsgrads der Batterie erfasst und der Berechnungseinrichtung zu Verfügung gestellt wird. Die Berechnungseinrichtung nutzt diese beiden Parameterwerte dann als Eingangsparameter für die Optimierungsrechnung und ermittelt hierdurch einen Steuerparameter in Abhängigkeit von den erfassten Parameterwerten der Temperatur und des Aufladungsgrads.

Gemäß einer Ausführungsform des erfindungsgemäßen Systems ist die Berechnungseinrichtung derart ausgebildet und eingerichtet, dass der Optimierungsparameter gemäß einer ersten Alternative ausgewählt ist aus der folgenden Gruppe von Optimierungsparametern: die modellierte Lebensdauer der Batterie, der modellierte Kapazitätsverlust der Batterie, die modellierte CO2-Emission eines mit der Batterie ausgestatteten Verbrauchersystems, der modellierte Eigenverbrauchsanteil eines mit der Batterie ausgestatteten Verbrauchersystems, die modellierten Stromkosten eines mit der Batterie ausgestatteten Verbrauchersystems; oder gemäß einer zweiten Alternative ein Summand von zweien oder mehr als zweien gewichteten Summanden ist, wobei die Summanden zumindest zum Teil ausgewählt sind aus der zuvor genannten Gruppe von Optimierungsparametern. Mit einer solchen Gewichtung können gleichzeitig mehrere Ziele mit einer für jedes Ziel individuellen Gewichtung verfolgt werden. Beispielsweise kann eine Maximierung der Lebensdauer bei gleichzeitiger Minimierung der Energiekosten ein Ziel sein, welches durch einen als Summe von entsprechenden gewichteten Summanden ausgebildeten Optimierungsparameter, verfolgt werden kann. Beispielsweise kann dabei der Gewichtungsfaktor für den Summanden, der die Maximierung der Lebensdauer beschreibt, größer sein als der Gewichtungsfaktor, der die Minimierung der Energiekosten beschreibt, sodass das Ziel der langfristigen Maximierung der Lebensdauer der Batterie höher gewichtet wird als das im Vergleich hierzu kurzfristigere Ziel der Minimierung der Energiekosten.

Unter einem Verbrauchersystem ist im Sinne der vorliegenden Erfindung ein System von Vorrichtungen zu verstehen, welches zusätzlich zu einer Batterie als Energiequelle auch Energieverbrauchende Vorrichtung als Energiesenken umfasst.

Die Begriffe "modellierte Lebensdauer" und "zu erwartende Lebensdauer" sowie äquivalante Begriffspaare werden im Sinne der vorliegenden Erfindung als Synonyme behandelt.

Insbesondere ist die Berechnungseinrichtung derart ausgebildet und eingerichtet, dass der Optimierungsparameter die modellierte Lebensdauer der Batterie ist. Dieser Optimierungsparameter hat sich in der Praxis als besonders wertvoll herausgestellt.

Physikalische Größen werden im Sinne der vorliegenden Erfindung mit dem Oberbegriff Parameter beschrieben, zunächst unabhängig davon ob sie zeitlich im Wesentlichen konstant oder zeitlich variabel sind. Zeitlich variable Parameter können alternativ auch als Variablen bezeichnet werden. Um Missverständnisse zu vermeiden, wird der Begriff Variable hier nicht verwendet. Zum Beispiel kann bei einer Optimierungsrechnung der Steuerparameter auch als Variable bezeichnet werden, da der Steuerparameter im Zuge der Optimierungsrechnung variiert werden kann, um ein Maxima des Optimierungsparameters zu identifizieren. In diesem Sinne wird mit dem Begriff "Parameter" die physikalische Größe als solche und mit dem Begriff "Variable" die berechnungstechnische Funktion einer physikalischen Größe beschrieben.

Gemäß einer Ausführungsform des erfindungsgemäßen Systems ist die Berechnungseinrichtung derart eingerichtet, dass das mathematische Modell ein linearisiertes mathematisches Modell eines nicht-linearen mathematischen Models des Alterungsprozesses der Batterie ist.

Insbesondere ist das mathematische Modell ein lineares Modell, welches einer zeitlichen Veränderung unterliegt. Dies bedeutet, dass Linearfaktoren, die einen linearen Zusammenhang zwischen einem Optimierungsparameter und einem Zustandsparameter beschreiben, ebenfalls einer auf die Zeit bezogenen Variation, insbesondere linearen Variation, unterliegen.

Gemäß einer weiteren Ausführungsform des erfindungsgemäßen Systems ist die Berechnungseinrichtung derart eingerichtet, dass die von der Berechnungseinrichtung durchgeführte Optimierungsrechnung ausschließlich das Lösen linearer Gleichungen beinhaltet.

Aus der Linearisierung ergibt sich der große Vorteil, dass die Optimierungsrechnung sehr schnell und sehr häufig durchgeführt werden kann, ohne dass übermäßig große Speicher und Prozessorkapazitäten benötigt werden. Dies ermöglichte eine Optimierung der Batteriesteuerung im Wesentlichen in Echtzeit, wodurch der Optimierungsgrad erhöht werden kann.

Gemäß einer Ausführungsform des erfindungsgemäßen Systems weist das System keinen Puffer-Speicher auf. Dies senkt die Komplexität des Systems und die mit dem System verbundenen Kosten.

Gemäß einer Ausführungsform des erfindungsgemäßen Systems ist die Berechnungseinrichtung derart ausgebildet und eingerichtet, dass ein Parameterwert des Zustandsparameters als Nullstelle einer linearen Näherung des nicht-linearen Models vordefiniert oder einstellbar ist und dass ein aus dieser linearen Näherung resultierendes lineares Modell als das mathematische Modell für die Optimierungsrechnung verwendet wird. Die Auswahl der Nullstelle für die Linearisierung ist mitentscheidend für die Genauigkeit der Linearisierung, d.h. die Abweichung zwischen dem linearen und dem nicht-linearen Modell bzw. den damit verbundenen Optimierungsrechnungen. An der Nullstelle der Linearisierung sagen sowohl das lineare - im Sinne von linearisiert - als auch das nicht-lineare Modell den gleichen Parameterwert für den Optimierungsparameter in Abhängigkeit vom Zustandsparameter voraus. In der Regel steigt die Abweichung zwischen der Vorhersage des linearen Models und der der Vorhersage des nicht-linearen Models dann mit steigender Entfernung von der Nullstelle. Mit anderen Worten ist eine Nullstelle einer linearen Näherung ist im Sinne der vorliegenden Erfindung derjenige Parameterwert, für den die Differenz zwischen der linearen Näherung und dem nicht-linearen Modell den Wert Null ergibt.

Insbesondere kann das lineare Modell auch mehrere Gleichungen umfassen, wobei jede Gleichung eine Linearisierung des nicht-linearen Models für ein begrenztes Parameterwertintervall des Zustandsparameters darstellt. So kann auch das nicht-lineare Modell über den gesamten Parameterwertbereich eines Zustandsparameters abschnittsweise durch mehrere linearisierte Gleichungen für jeweils benachbarte Parameterwertintervalle abgedeckt werden, wobei für jedes dieser Parameterwertintervalle eine eigene Nullstelle innerhalb dieses Parameterwertintervalls für die Linearisierung verwendet wird.

Unter einem linearen Modell ist im Sinne der vorliegenden Anmeldung folglich insbesondere auch eine stückweise lineare Funktion zu verstehen. Linearisierung bedeutet dabei, dass eine stückweise lineare Funktion für die gesamte nicht-lineare Kurve erzeugt wird, bei der die kontinuierlichen nicht differenzierbaren Punkte dieser Funktion die Punkte mit dem häufigsten Auftreten und einem Null-Fehler in Bezug auf die ursprüngliche nicht-lineare Funktion sind, d. h. an diesen Punkten ist der Funktionswert des linearen Modells gleich dem Funktionswert des nicht-linearen Modells. Die Funktion kann auch so gestaltet werden, dass die nicht differenzierbaren Punkte an anderen Stellen liegen, aber an den häufigst auftretenden Punkten jeweils einen Nullfehler erzeugen. In beiden Fällen wird das nicht-lineare Modell in ein lineares Modell umgewandelt, bei dem der Fehler für den am häufigsten auftretenden Punkt Null ist und der Fehler für die gesamte Funktion minimal ist.

Gemäß einer Ausführungsform des erfindungsgemäßen Systems ist die Berechnungseinrichtung derart ausgebildet und eingerichtet, dass die Berechnungseinrichtung die Häufigkeitsverteilung des Auftretens von Parameterwerten des Zustandsparameters detektiert und eine Linearisierung des nicht-linearen mathematischen Models in Abhängigkeit von der detektierten Häufigkeitsverteilung durchführt, um das linearisierte mathematische Modell zu erhalten, wobei insbesondere zumindest ein Linearisierungsparameterwert des Zustandsparameters in Abhängigkeit von der Häufigkeitsverteilung berechnet wird und die Linearisierung des nicht linearen mathematischen Models derart ausgebildet ist, dass der für den Linearisierungsparameterwert berechenbare Optimierungsparameterwert für das linearisierte und das nicht-lineare mathematische Modell identisch ist.

Beispielsweise kann hierbei eine Linearisierung des nicht-linearen Modells nicht nur vorab sondern auch on-site innerhalb der Berechnungseinrichtung erfolgen. Für die Durchführung der Optimierungsrechnung können dann dennoch nur die linearen Gleichungen des linearen Models gelöst werden. Ein Linearisierungsparameterwert des Zustandsparameters ist jedenfalls durch die verwendete Nullstelle für die Linearisierung gegeben. So kann die Berechnungseinrichtung die Auswahl der Nullstelle oder der Nullstellen an die Häufigkeitsverteilung des Zustandsparameters anpassen, indem zu den voreingestellten Nullstellen (Linearisierungsparameterwerten) im Betrieb weitere Nullstellen (Linearisierungsparameterwerte) hinzugefügt werden. Dies sorgt dafür, dass das lineare Modell für diejenigen Parameterwerte, die häufig im Betrieb auftreten, bzw. die damit verbundenen Wertebereiche genauere Vorhersagen trifft, also geringere Abweichungen zum nicht-linearen Modell aufweist. Eine an der Häufigkeitsverteilung des Zustandsparameters ausgerichtete Initialisierung der Nullstellen für die Linearisierung kann regelmäßig erfolgen, vorzugsweise aber mit einer größere Periode als der Periode für die Durchführung der Optimierungsrechnung, um Rechenkapazitäten zu schonen, zum Beispiel einmal jährlich.

Gemäß einer Ausführungsform des erfindungsgemäßen Systems ist die Berechnungseinrichtung derart ausgebildet und eingerichtet, dass zumindest ein Linearisierungsparameterwert des Zustandsparameters voreingestellt ist und die Linearisierung des nicht linearen mathematischen Models derart ausgebildet ist, dass der für den Linearisierungsparameterwert berechenbare Optimierungsparameterwert für das linearisierte und das nicht-lineare mathematische Modell identisch ist. Vorzugsweise ist die Berechnungseinrichtung derart ausgebildet, dass 2 bis 10, besonders bevorzugt 3 bis 6, unterschiedliche Linearisierungsparameterwerte des Zustandsparameters voreingestellt sind. Die Linearisierungsparameterwerte können insbesondere eine inhomogene Abstandsverteilung aufweisen.

Gemäß einer Ausführungsform des erfindungsgemäßen Systems ist die Berechnungseinrichtung derart ausgebildet und eingerichtet, dass mit dem mathematischen Modell der für den zumindest einen Linearisierungsparameterwert berechenbare Optimierungsparameterwert zeitlich variiert wird. Hierdurch können besonders einfach nicht-lineare multivariable Abhängigkeiten des Optimierungsparameters in ein lineares Modell überführt werden und somit eine schnelle und energieeffiziente Berechnung, Optimierung und Steuerung der Batterie ermöglicht werden.

Gemäß einer Ausführungsform des erfindungsgemäßen Systems umfasst ein erster Wertebereich des Zustandsparameters, für den eine größere Häufigkeit des Auftretens im Betrieb des Systems oder während einer vor dem Normalbetrieb erfolgenden Initialisierungsphase detektiert wird als für einen zweiten Wertebereich des Zustandsparameters, mehr Linearisierungsparameterwerte als der zweite Wertebereich.

Insbesondere kann das System inklusive der Berechnungseinrichtung in einem Auslieferungszustand bereits entsprechend eingerichtet sein, sodass eine regelmäßig erfolgende Neu-Initialisierung der Linearisierungsparameterwerte im Sinne von Nullstellen der Linearisierung nicht durch die Berechnungseinrichtung erfolgen muss, sodass die Berechnungseinrichtung nur verhältnismäßig geringe Prozessor- und Speicherkapazitäten benötigt.

Zum Beispiel kann das der Optimierungsrechnung zugrundeliegende mathematische Modell derart ausgebildet sein, dass der Kapazitätsverlust der Batterie als Optimierungsparameter in Abhängigkeit von der Entladungstiefe (engl. Depth of Discharge, DoD) berechnet wird. Initial, d.h. vor einem Normalbetrieb der Batterie und des Systems zum Steuern der Batterie, können dann als Linearisierungsparameterwerte der Entladungstiefe die Werte 10%, 80%, 80% und 100% voreingestellt festgelegt werden. Diese Linearisierungsparameterwerte verändern sich dann während des Normalbetriebes nicht. Das linearisierte mathematische Modell ist dann aus den zwischen den oben genannten Linearisierungsparameterwerten der Entladungstiefe interpolierten Werten des Kapazitätsverlustes gegeben bzw. den unterhalb von 10% Entladungstiefe extrapolierten Werten des Kapazitätsverlustes gegeben. Die Berechnungseinrichtung kann aber derart ausgebildet sein, dass die den Linearisierungsparameterwerten im Modell zugeordneten Optimierungsparameterwerte, welche mit den Werten des zugrunde-liegenden nicht-linearen Models identisch gehalten werden, im Normalbetrieb mit der Zeit adaptiv verändert werden, beispielsweise durch eine dem nicht-linearen Modell zugrunde liegende zeitliche Variation des Optimierungsparameters. So kann das Modell zum Beispiel derart auf der Berechnungseinrichtung eingerichtet sein, dass der Kapazitätsverlust pro Zeitraum T, also pro Optimierungsfenster (hier z.B. pro Tag), bei dem Linearisierungsparameterwert von 60% des Entladungsgrads (auch Entladungstiefe genannt) nach 1 Jahr Betriebslaufzeit der Batterie 2,5 10^-5 Prozent/Tag beträgt, aber nach 2 Jahren Betriebslaufzeit der Batterie 3,5 10^-5 Prozent/Tag beträgt. Dem liegt ein lineares Modell des Optimierungsparameters "Kapazitätsverlust pro Tag" zugrunde.

Gemäß einer Ausführungsform des erfindungsgemäßen Systems ist die Berechnungseinrichtung derart ausgebildet und eingerichtet, dass eine Durchführung der Optimierungsrechnung mit einer nachgelagerten Anpassung des Parametwerts des Steuerparameters mindestens einmal täglich, vorzugsweise mindestens einmal stündlich und besonders bevorzugt mindestens einmal pro Viertelstunde erfolgt. Je enger die Taktung, desto höher ist der Optimierungsgrad, der erreicht werden kann. Dabei sind die Opportunitätskosten für die Durchführung der Optimierungsrechnung zu berücksichtigen. Die hier beschriebenen Taktungen haben sich vor diesem Hintergrund als ausgeglichene Lösungen zwischen diesen beiden konträren Positionen herausgestellt - Optimierungsgrad auf der einen Seite und Opportunitätskosten auf der anderen Seite.

Gemäß einer Ausführungsform des erfindungsgemäßen Systems weist die Datenerfassungseinrichtung eine erste Datenkommunikationsschnittstelle auf, wobei die Berechnungseinrichtung eine zweite Datenkommunikationsschnittstelle aufweist, wobei die Datenerfassungseinrichtung derart ausgebildet und eingerichtet ist, dass der von der Datenerfassungseinrichtung erfassten Parameterwert über die ersten Datenkommunikationsschnittstelle und die zweite Datenkommunikationsschnittstelle übermittelt wird, damit der erfasste Parameterwert von der Berechnungseinrichtung verwendet werden kann, wobei die erste und die zweite Datenkommunikationsschnittstelle vorzugsweise jeweils als kabellose Datenübertragungsschnittstelle, insbesondere 5G-Schnittstelle, ausgebildet sind. Dies ermöglicht insbesondere eine Migration der Berechnungseinrichtung in eine Cloud. Dies erleichtert wiederum das Management und die Wartung der Berechnungseinrichtung. Außerdem wird der Hardwarebedarf unmittelbar an der Batterie on-site auf ein Minimum reduziert

Gemäß einer Ausführungsform des erfindungsgemäßen Systems ist die Berechnungseinrichtung auf einem physischen oder virtuellen Server räumlich beabstandet von der Batterie angeordnet, wobei die Berechnungseinrichtung auf einem physischen oder virtuellen Server räumlich beabstandet von der Datenerfassungseinrichtung angeordnet ist.

Gemäß einer Ausführungsform des erfindungsgemäßen Systems umfasst das System einen Computer, insbesondere einen Mikrocontroller, wobei der Computer die Steuereinrichtung umfasst. Vorzugsweise kann der Computer, insbesondere Mikrocontroller, auch die Datenerfassungseinrichtung umfassen. Die Steuerungseinrichtung und die Datenerfassungseinrichtung können hierdurch als eine kompakte Hardwarekomponente ausgebildet sein und universell für die Steuerung von Batterien eingesetzt werden. Gemäß einer weiteren Ausführungsform ist auch die Berechnungseinrichtung in dem Computer, insbesondere dem Mikrocontroller, integriert. Das System kann dann hierdurch zumindest zeitweise vollständig autark arbeiten.

Gemäß einer Ausführungsform des erfindungsgemäßen Systems umfasst das System auch die Batterie, welche von der Steuereinrichtung gesteuert wird.

Die vorliegende Erfindung betrifft zudem auch ein computer-implementiertes Verfahren zum Steuern des Lade- oder Entladevorgangs einer Batterie, wobei das Verfahren die folgenden Schritte aufweist: (A) Bestimmen eines Zustandsparameters der Batterie; (B) Bestimmen eines Parameterwertes eines Steuerparameters durch Lösen einer von dem Zustandsparameter abhängigen Optimierungsgleichung; (C) Steuern des Lade- oder Entladevorgangs in Abhängigkeit von dem in Schritt B bestimmten Parameterwert des Steuerparameters.

Die vorliegende Erfindung betrifft zudem die Verwendung eines erfindungsgemäßen Systems innerhalb eines Energienetzwerks zum Abfedern von Leistungsspitzen- und senken.

Als Zustandsparameter und Steuerparameter kommen dabei alle im Bezug auf das System beschriebenen Parameter in Frage. Auch können die in Bezug auf das System beschriebenen Verfahrensschritte Bestandteile des hier beschriebenen Verfahrens darstellen - und umgekehrt.

Die Merkmale aller hier beschriebenen Ausführungsformen des erfindungsgemäßen Systems und des erfindungsgemäßen Verfahrens können kombiniert werden, sofern keine logischen Ausschlüsse benannt sind.

Weitere Merkmale, Vorteile und Anwendungsmöglichkeiten der vorliegenden Erfindung werden deutlich anhand der folgenden Beschreibung bevorzugter Ausführungsformen und der dazugehörigen Figuren. Es zeigen:
Fig. 1: eine erste Ausführungsform des erfindungsgemäßen Systems,
Fig. 2: eine zweite Ausführungsform des erfindungsgemäßen Systems,
Fig. 3: eine dritte Ausführungsform des erfindungsgemäßen Systems,
Fig. 4: ein Diagramm mit Resultaten eines nicht-linearen Models und eines linearisierten Models, auf dem eine Optimierungsrechnung des erfindungsgemäßen Systems aufbaut.

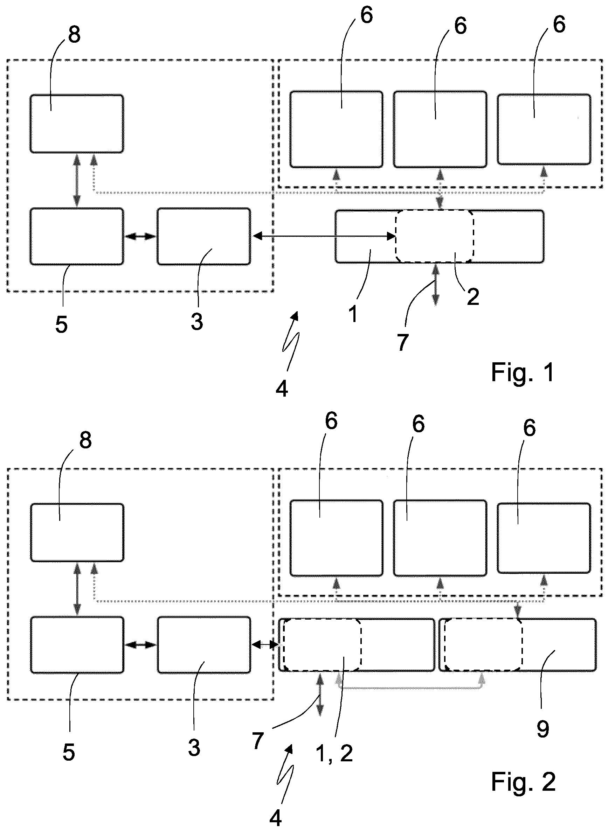

In Fig. 1 ist eine Batterie 5 gezeigt, die über ein Batterie-Management-System 3 verfügt. Mit dem Batterie-Management-System 3 können die an der Batterie anliegende Spannung, die Stärke des Auflade- oder Entladestroms sowie die in der Batterie herrschende Temperatur bestimmt werden. Das Batterie-Management-System 3 ist somit ein Bestandteil der Datenerfassungseinrichtung der hier gezeigten Ausführungsform, mit dem Parameterwerte dieser Zustandsparameter direkt bestimmt und über eine Schnittstelle der Berechnungseinrichtung 2 zu Verfügung gestellt werden können. Dieser Verbindung ist ein zweiter Bestandteil 1 der Datenerfassungseinrichtung vorgeschaltet oder hierzu parallelgeschaltet, mit der weitere Zustandsparameter wie beispielsweise der Aufladungsgrad oder der zeitlich gemittelte Aufladungsgrad bestimmt werden können. Auch die hierdurch bestimmten Parameterwerte der jeweiligen Zustandsparameter werden der Berechnungseinrichtung 2 zu Verfügung gestellt.

Bei der in der Fig. 1 gezeigten Ausführungsform sind die Berechnungseinrichtung 2 und beide Bestandteile der Datenerfassungseinrichtung 1, 3 hardwaretechnisch integral mit dem Batterie-Management-System 3 ausgebildet.

Die Batterie ist zudem mit einer Ladekontrolleinheit 8 inklusive Wechselrichter verbunden, die eine Verbindung der Batterie zu einer externen Stromquelle 6 herstellt, mit der die Batterie aufgeladen werden kann. Diese externe Stromquelle 6 kann beispielsweise ein System regenerativer Stromquellen wie Solarzellen oder auch das allgemeine Stromnetz sein, an das die Batterie in diesem Fall über die Ladekontrolleinheit 8 angeschlossen wäre.

Die Ladekontrolleinheit 8 stellt zusammen mit dem Batterie-Management-System 3 die Steuereinrichtung dar, über die zeitliche Profile des Lade- oder Entladestroms beim Auf- bzw. Entladen der Batterie gesteuert werden können. Zu diesem Zweck ist auch die Ladekontrolleinheit 8 über eine bidirektionale Datenverbindung mit der Berechnungseinrichtung 2 verbunden, sodass sowohl das Batterie-Management-System 3 als auch die Ladekontrolleinheit 8 den oder die von der Berechnungseinrichtung 2 durch die Optimierungsrechnung ermittelten Steuerparameterwert(e) erhält und den Lade- bzw. Entladevorgang in Abhängigkeit von diesem oder diesen Steuerparameterwert(en) steuert.

Bei der in der Fig. 1 gezeigten Ausführungsform bilden zumindest das Batterie-Management-System 3, der zweite Bestandteil 1 der Datenerfassungseinrichtung, die Berechnungseinrichtung 2 und die Ladekontrolleinheit 8 das System 4 zum optimierten Steuern der Batterie 5.

Die in Fig. 2 gezeigte Ausführungsform unterscheidet sich von dem in Fig. 1 gezeigten System nur dahingehend, dass die Steuereinrichtung einen zusätzlichen realen oder virtuellen Prozessor - das Energie-Management-System 9 - umfasst. Dieser ist zwischen der Berechnungseinrichtung 2 und Ladekotrolleinheit 8 zwischengeschaltet und empfängt die Steuerparameterwerte von der Berechnungseinrichtung 2, um diese in Steuerbefehle für die Ladekontrolleinheit 8 umzuwandeln.

In der Praxis existieren sowohl Batteriesysteme, die über ein Energie-Management-System 9 verfügen, als auch solche, bei denen dies nicht der Fall ist. Für letztere zeigt die Fig. 1 eine mögliche Implementierung des erfindungsgemäßen Systems - für erstgenannte Systeme die Fig. 2.

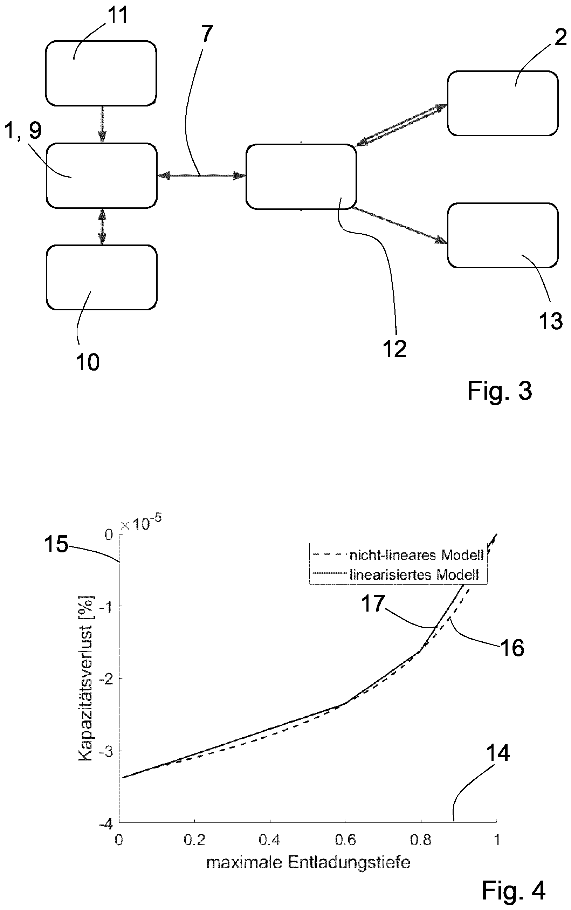

Fig. 3 zeigt nun, wie eine Ausführungsform des erfindungsgemäßen System 4 teilweise ausgebildet sein kann, wenn die Optimierungsrechnungen cloud-basiert erfolgen. In dem hier gezeigten Beispiel verfügt die Batterie über ein Energie-Management-System 9. Dieses ist bi-direktional mit dem Batterie-Management-System verbunden (nicht gezeigt). Das Energie-Management-System 9 ist zudem bi-direktional mit kontrollierbaren Verbrauchern 10 der in der Batterie gespeicherten Energie verbunden, deren Stromverbrauch von dem Energie-Management-System 9 kontrolliert werden kann. Möglich ist auch, dass das Energie-Management-System 9 mit nicht-kontrollierbaren Verbrauchern 11 verbunden ist, sodass das Energie-Management-System 9 Informationen über den Stromverbrauch dieser Verbraucher 11 erhält, aber keinen Einfluss auf diesen Verbrauch 11 nehmen kann. Das Energie-Management-System 9 erhält zudem die von der Datenerfassungseinrichtung erfassten Parameterwerte des oder der verwendeten Zustandsparameter und stellt diese über eine kabellose Datenverbindung 7 dem Cloud-Server 12 zu Verfügung.

Die Berechnungseinrichtung 2 ist nun in dem Cloud-Server integriert oder mit diesem verbunden. Mit den erhaltenen Parameterwerten für den oder die Zustandsparameter als Eingangsparameterwerte führt die Berechnungseinrichtung die Optimierungsrechnung durch, die auf dem vordefinierten mathematischen Modell des Alterungsprozesses der Batterie basiert. Mit anderen Worten wird ein vordefinierter Solver in Form eines Algorithmus ausgeführt, bei dem die empfangenen Parameterwerte des oder der Zustandsparameter als Konstante bzw.

Konstanten behandelt werden. Der Solver ist dabei derart eingerichtet, dass ein Optimierungsparameter - wie beispielsweise der Kapazitätsverlust - minimiert wird (oder in anderen Fällen maximiert wird) und hierdurch ein Parameterwert für einen Steuerparameter - wie beispielsweise den maximalen Aufladestrom - ermittelt wird. Dieser Parameterwert des Steuerparameters wird sodann über die bi-direktionale kabellose Datenverbindung 7 wieder dem Energie-Management-System 9 zu Verfügung gestellt, sodass diese den Auflade- oder Entladevorgang der Batterie entsprechend steuert - im Beispiel bleibend, zusammen mit der Ladekontrolleinheit (hier nicht gezeigt) den maximalen Ladestrom gemäß dem von der Berechnungseinrichtung ermittelten Parameterwert festlegt.

Zur Kontrolle und Modifikation der Optimierungsrechnung und deren Ergebnis werden die erfassten und berechneten Parameterwerte für Zustandsparameter, Optimierungsparameter und Steuerparameter für den Nutzer auf einem Dashboard 13 übersichtlich angezeigt.

Damit der im vorherigen Abschnitt beschriebene Prozess besonders schnell und energieeffizient ablaufen kann, kann die Optimierungsrechnung statt auf einem realitäts-näheren nicht-linearen Modell des Alterungsprozesses der Batterie, auf einem linearisierten Modell dieses nicht-linearen Modell beruhen. Der Linearisierungsprozess ist beispielhaft in dem Diagramm Fig. 4 für den Zusammenhang von Entladungsgrad 14 (als Zustandsparameter auf der x-Achse) und Kapazitätsverlust 15 (als Optimierungsparameter auf der y-Achse) gezeigt.

Der Kurvenverlauf 16 des nicht-linearen Models für diesen Zusammenhang ist dem Kurvenverlauf 17 eines stückweise linearisierten Models gegenübergestellt. Das linearisierte Modell weist in diesem Fall insgesamt vier Linearisierungsparameterwerte des Entladungsgrads 14 auf (hier bei ca. 10%, 60%, 80% und 100%) für die die dazugehörigen Werte des Kapazitätsverlustes im nicht-linearen Modell identisch sind. Diese Linearisierungsparameterwerte sind Nullstellen im Sinne der vorliegenden Erfindung. Denn bei diesen Werten des Entladungsgrades ist der Abstand zwischen dem linearisierten Model 17 und dem nicht-linearisierten Model 16 gleich Null. Die bezogen auf den Wertebereich des Entladungsgrad dazwischenliegenden Werte des Kapazitätsverlustes sind hier durch Interpolation im linearisierten Modell abgeschätzt, die außerhalb des Bereiches (< 10%) liegenden Werte durch Extrapolation. Die Anwendung eines solchen linearisierte Models bei der Optimierungsrechnung reduziert die für die Berechnung benötigten Rechenkapazitäten immens und ermöglicht somit eine Optimierung der Batteriesteuerung nahezu in Echtzeit.

Für Zwecke der ursprünglichen Offenbarung wird darauf hingewiesen, dass sämtliche Merkmale, bzw. Ausführungsformen wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

### Bezugszeichenliste

- 1: Bestandteil der Datenerfassungseinrichtung/Prozessor
- 2: Berechnungseinrichtung/Prozessor
- 3: Batterie-Management-System (Teil der Steuereinrichtung und/oder der Datenerfassungseinrichtung)
- 4: System zum optimierten Steuern einer Batterie
- 5: Batterie
- 6: Externe Stromquellen
- 7: Datenverbindung
- 8: Ladekontrolleinheit mit Wechselrichter (Teil der Steuereinrichtung)
- 9: Energie-Management-System
- 10: Kontrollierbare Verbraucher (Energiesenken)
- 11: Nicht-kontrollierbare Verbraucher (Energiesenken)
- 12: Cloud-Server
- 13: Endgerät mit Dashboard-Anwendung
- 14: Parameterwertbereich der Zustandsparameters: Entladetiefe (Depth od Discharge, DoD)
- 15: Parameterwertbereich des Optimierungsparameters: Kapazitätsverlust (Capacity loss)
- 16: Wertekurve gemäß nichtlinearem Model
- 17: Wertekurve gemäß abschnittsweisem linearisierten Model

## Patentansprüche

1. System zum optimierten Steuern einer Batterie,
wobei das System eine Datenerfassungseinrichtung umfasst,
wobei das System eine Berechnungseinrichtung umfasst,
wobei das System eine Steuereinrichtung umfasst,
wobei die Datenerfassungseinrichtung derart ausgebildet und eingerichtet ist, dass sie einen Parameterwert eines physikalischen und zeitlich variablen Zustandsparameters einer Batterie erfasst und der Berechnungseinrichtung zu Verfügung stellt,
wobei die Berechnungseinrichtung derart ausgebildet und eingerichtet ist, dass die Berechnungseinrichtung mittels einer Optimierungsrechnung einen Parameterwert eines Steuerparameters ermittelt,
wobei die Berechnungseinrichtung derart eingerichtet ist, dass mit der Optimierungsrechnung ein Optimierungsparameter minimiert oder maximiert wird,
wobei die Berechnungseinrichtung derart eingerichtet ist, dass die Berechnungseinrichtung die Optimierungsrechnung in Abhängigkeit von einem mathematischen Modell des zeitlichen Verhaltens der Batterie durchführt, wobei mit dem mathematischen Modell der Optimierungsparameter in Abhängigkeit von dem Zustandsparameter berechenbar ist,
wobei die Berechnungseinrichtung derart eingerichtet ist, dass die Berechnungseinrichtung bei der Durchführung der Optimierungsrechnung den von der Datenerfassungseinrichtung erfassten und der Berechnungseinrichtung zu Verfügung gestellten Parameterwert des physikalischen und zeitlich variablen Zustandsparameters als Eingangsparameterwert für die Optimierungsrechnung verwendet,
wobei die Steuereinrichtung derart ausgebildet und eingerichtet ist, dass die Steuereinrichtung ein Entladen der Batterie in Abhängigkeit von dem ermittelten Parameterwert des Steuerparameters steuert.

2. System gemäß Anspruch 1,
wobei die Steuereinrichtung derart ausgebildet ist, dass die Steuereinrichtung den zeitlichen Verlauf des Entlade-Stroms in Abhängigkeit von dem ermittelten Parameterwert des Steuerparameters steuert.

3. System gemäß einem der voranstehenden Ansprüche,
wobei der Steuerparameter ausgewählt ist aus der folgenden Gruppe von möglichen Steuerparametem: Status des Entladens mit den beiden einzig möglichen Parameterwerten on und off, Startzeit des Entladens, Stoppzeit des Entladens, Maximaler Entlade-Strom.

4. System gemäß einem der voranstehenden Ansprüche,
wobei der Zustandsparameter ausgewählt ist aus der folgenden Gruppe von möglichen Zustandsparametern: Aufladungsgrad der Batterie, Entladungsgrad der Batterie, Energiefluss in die Batterie beim Aufladen, Energiefluss aus der Batterie beim Entladen, Temperatur der Batterie, Alter der Batterie, gemittelter Aufladungsgrad über einen Zeitraum T, gemittelter Entladungsgrad über einen Zeitraum T, Maximaler Entladungsgrad in einem Zeitraum T, wobei der Zeitraum T insbesondere gleich 24 Stunden oder 1 Stunde oder 15 Minuten ist.

5. System gemäß einem der voranstehenden Ansprüche,
wobei die Datenerfassungseinrichtung derart ausgebildet und eingerichtet ist, dass die Datenerfassungseinrichtung eine an der Batterie anliegende elektrische Spannung, einen in die oder aus der Batterie fließenden elektrischen Strom und eine in der Batterie herrschenden Temperatur misst,
wobei die Datenerfassungseinrichtung vorzugsweise derart ausgebildet und eingerichtet ist, dass die Datenerfassungseinrichtung den Aufladungsgrad der Batterie oder den Entladungsgrad der Batterie auf Basis der gemessenen Spannung und/oder des gemessenen Stroms und/oder der gemessenen Temperatur bestimmt.

6. System gemäß einem der voranstehenden Ansprüche,
wobei die Berechnungseinrichtung derart ausgebildet und eingerichtet ist, dass mit der auf dem mathematischen Modell beruhenden Optimierungsrechnung der Optimierungsparameter in multivariabler Abhängigkeit von mehreren der folgenden Zustandsparametem berechenbar ist: Aufladungsgrad der Batterie, Entladungsgrad der Batterie, Energiefluss in die Batterie beim Aufladen, Energiefluss aus der Batterie beim Entladen, Temperatur der Batterie, Alter der Batterie, gemittelter Aufladungsgrad über einen Zeitraum T, gemittelter Entladungsgrad über einen Zeitraum T, Maximaler Entladungsgrad in einem Zeitraum T; wobei die Datenerfassungseinrichtung zumindest Parameterwerte derjenigen Zustandsparameter erfasst, von denen das mathematische Modell abhängig ist, und der Berechnungseinrichtung zu Verfügung stellt.

7. System gemäß einem der voranstehenden Ansprüche,
wobei die Berechnungseinrichtung derart ausgebildet und eingerichtet ist, dass der Optimierungsparameter gemäß einer ersten Alternative die modellierte Lebensdauer der Batterie ist;
oder gemäß einer zweiten Alternative ein Summand von zweien oder mehr als zweien gewichteten Summanden ist, wobei ein Summand die modellierte Lebensdauer der Batterie ist.

8. System gemäß einem der voranstehenden Ansprüche,
wobei die Berechnungseinrichtung derart eingerichtet ist, dass das mathematische Modell ein linearisiertes mathematisches Modell eines nicht-linearen mathematischen Models des Alterungsprozesses der Batterie, vorzugsweise ein sich zeitlich veränderndes lineares Modell, ist.

9. System gemäß einem der voranstehenden Ansprüche,
wobei die Berechnungseinrichtung derart ausgebildet und eingerichtet ist, dass ein Parameterwerte des Zustandsparameters als Nullstelle einer linearen Näherung des nicht-linearen Models vordefiniert oder einstellbar ist und dass aus dieser linearen Näherung resultierende lineare Modell für die Optimierungsrechnung verwendet wird, wobei die Nullstelle einer linearen Näherung derjenige Parameterwert ist, für den die Differenz zwischen der linearen Näherung und dem nicht-linearen Modell den Wert Null ergibt.

10. System gemäß einem der voranstehenden Ansprüche,
wobei die Berechnungseinrichtung derart ausgebildet und eingerichtet ist, dass zumindest ein Linearisierungsparameterwert des Zustandsparameters voreingestellt ist und die Linearisierung des nicht linearen mathematischen Models derart ausgebildet ist, dass der für den Linearisierungsparameterwert berechenbare Optimierungsparameterwert für das linearisierte und das nicht-lineare mathematische Modell identisch ist, wobei vorzugsweise die Berechnungseinrichtung derart ausgebildet ist, dass 2 bis 10, besonders bevorzugt 3 bis 6, unterschiedliche Linearisierungsparameterwerte des Zustandsparameters voreingestellt sind.

11. System gemäß dem voranstehenden Anspruch,
wobei die Berechnungseinrichtung derart ausgebildet und eingerichtet ist, dass mit dem mathematischen Modell der für den zumindest einen Linearisierungsparameterwert berechenbare Optimierungsparameterwert zeitlich variiert wird.

12. System gemäß einem der voranstehenden Ansprüche,
wobei die Berechnungseinrichtung derart ausgebildet und eingerichtet ist, dass eine Durchführung der Optimierungsrechnung mit einer nachgelagerten Anpassung des Parametwerts des Steuerparameters mindestens einmal stündlich und vorzugsweise mindestens einmal pro Viertelstunde erfolgt.

13. System gemäß einem der voranstehenden Ansprüche,
wobei die Datenerfassungseinrichtung eine erste Datenkommunikationsschnittstelle aufweist,
wobei die Berechnungseinrichtung eine zweite Datenkommunikationsschnittstelle aufweist,
wobei die Datenerfassungseinrichtung derart ausgebildet und eingerichtet ist, dass der von der Datenerfassungseinrichtung erfassten Parameterwert über die ersten Datenkommunikationsschnittstelle und die zweite Datenkommunikationsschnittstelle übermittelt wird, damit der erfasste Parameterwert von der Berechnungseinrichtung verwendet werden kann,
wobei die erste und die zweite Datenkommunikationsschnittstelle vorzugsweise jeweils als kabellose, vorzugsweise internet-fähige, Datenübertragungsschnittstelle, insbesondere 3G-, 4G-, 5G-, oder WLAN-Schnittstelle, ausgebildet sind.

14. System gemäß einem der voranstehenden Ansprüche,
wobei die Berechnungseinrichtung auf einem physischen oder virtuellen Server räumlich beanstandet von der Batterie angeordnet ist,
wobei die Berechnungseinrichtung auf einem physischen oder virtuellen Server räumlich beanstandet von der Datenerfassungseinrichtung angeordnet ist.

15. Computer-implementiertes Verfahren zum Steuern Entladevorgangs einer Batterie, wobei das Verfahren die folgenden Schritte aufweist:
A) Bestimmen eines Zustandsparameters der Batterie,
B) Bestimmen eines Parameterwertes eines Steuerparameters durch Lösen einer von dem Zustandsparameter abhängigen Optimierungsgleichung, wobei die Optimierungsgleichung abhängig ist von einem mathematischen Modell des Alterungsprozesses der Batterie,
C) Steuern des Lade- oder Entladevorgangs in Abhängigkeit von dem in Schritt B bestimmten Parameterwert des Steuerparameters.
